# FASCICULE DE BREVET EUROPEEN

(11) **EP 1 788 514 B1**
(45) Date de publication et mention de la délivrance du brevet: **08.04.2009**
(21) Numéro de dépôt: 06023093.5
(22) Date de dépôt: 07.11.2006
(51) Int. Cl.: G06K 19/077, H01L 23/48

(54) **Micromodule électronique et procédé de fabrication**
Elektronisches Mikromodul und Herstellungsverfahren
Electronic micromodule and method of fabrication

(30) Priorité: 21.11.2005 FR 0511750
(43) Date de publication de la demande: 23.05.2007
(73) Titulaire: STMICROELECTRONICS SA, 92120 Montrouge (FR)
(72) Inventeur: Rogge, Agnès, 13114 Puyloubier (FR)
(74) Mandataire: Marchand, André

(56) Documents cités:
- EP-A- 1 069 645
- EP-A- 1 467 315
- WO-A-00/77852
- WO-A-01/45164
- US-A- 5 387 551
- US-B1- 6 268 796

## Description

La présente invention concerne un procédé de fabrication d'un micromodule électronique, et plus particulièrement un micromodule sans contact comprenant un circuit intégré et une bobine d'antenne connectée électriquement au circuit intégré.

Un circuit intégré se présente généralement sous la forme d'une microplaquette de silicium (puce) qui comporte une région active implantée dans le silicium, et des plages de contact reliées électriquement à la région active. Certains circuits intégrés dits sans contact, tels les circuits PICC (Proximity Inductive Coupling Circuit) décrits par les normes ISO/IEC 14443 et 15693, sont destinés à être connectés à une bobine d'antenne assurant l'interface entre le circuit intégré et le milieu extérieur, pour la réception et l'émission de données. Des tels circuits intégrés comprennent des moyens pour recevoir et/ou émettre des données par couplage inductif par l'intermédiaire de la bobine d'antenne, en présence d'un champ magnétique émis par une station d'émission et/ou de réception de données. Ils permettent de réaliser des micromodules électroniques sans contact qui sont fixés sur ou dans des objets portatifs tels une carte en plastique, un jeton, une clé, un livre, etc. à des fins d'authentification et/ou d'identification des objets portatifs.

Un procédé de fabrication souvent utilisé pour réaliser un micromodule sans contact consiste à prévoir une plaquette support en papier ou en matière plastique sur laquelle la bobine d'antenne est réalisée par sérigraphie d'une pâte conductrice ou gravure d'une couche conductrice. Le circuit intégré est ensuite posé sur la plaquette support, et ses plages de contact sont connectées à la bobine.

Ce procédé impose toutefois des contraintes technologiques en ce qui concerne l'épaisseur et la surface du micromodule. Ainsi, l'épaisseur totale de la plaquette support et de la bobine d'antenne ne peut être réduite en deçà d'un minimum de l'ordre de 100 µm. Egalement, le pas technologique (distance minimale entre conducteurs) offert par les techniques de sérigraphie ou de gravure sur support papier ou plastique impose une taille de bobine assez importante et nettement supérieure à la taille du circuit intégré.

On connaît également un procédé de fabrication dit "coil on chip" (bobine sur puce), consistant à réaliser des bobines directement sur des circuits intégrés alors que ceux-ci sont encore présents sur une plaquette de silicium (wafer), avant la découpe de la plaquette en microplaquettes de silicium. Ce procédé consiste à déposer une couche isolante sur la face active de la plaquette de silicium (face comprenant les régions actives des circuits intégrés) puis à former les bobines sur la couche isolante supérieure. Après découpe de la plaquette de silicium, on obtient des micromodules intégrés. Le document US 5 387 551 décrit la formation d'une bobine sur une couche isolante déposée sur une plaquette de silicium.

Un tel procédé permet de supprimer plusieurs étapes d'assemblage et de connexion mais s'avère peu fiable et ne présente pas un rendement optimum : de nombreux micromodules ainsi obtenus ne fonctionnement pas correctement et doivent être mis au rebut. Ce problème provient notamment du fait que la face active du circuit intégré peut ne pas être plane, notamment en raison de la présence d'éléments conducteurs sous la couche isolante. Il en résulte que l'épaisseur de la couche isolante séparant la bobine et la surface active du circuit intégré n'est pas constante et est parfois insuffisante pour éviter l'apparition de couplages capacitifs ou inductifs entre le circuit intégré et la bobine. En outre, des ouvertures sont réalisées dans la couche isolante en regard des plages de contact du circuit intégré pour assurer le contact électrique et mécanique du circuit intégré avec l'antenne. Il en résulte des irrégularités importantes à la surface de la couche isolante ("marches d'escalier") qui peuvent également provoquer des discontinuités électriques dans le matériau conducteur formant la bobine (insuffisance de matériau conducteur sur les flancs des marches). En outre, les diélectriques mal polymérisés évoluent dans le temps et ne permettent pas une accroche stable du métal. Enfin, un mauvais nettoyage après gravure du métal peut avoir un effet corrosif sur le conducteur et provoquer une coupure de la piste conductrice.

Le document US 6 268 796 décrit un micromodule formé d'une microplaquette de circuit intégré assemblée à une microplaquette sur laquelle est formée une antenne avec des plages de connexion formées de manière à coïncider avec les plages de connexion du circuit intégré lorsque les deux microplaquettes sont assemblées l'une contre l'autre. L'antenne présente la forme d'un enroulement formé par un dépôt de pistes conductrices sur les deux faces de la microplaquette.

Le document WO 01/45164 décrit la formation d'un trou métallisé dans une plaquette de circuit intégré, en formant un trou borgne sur une face de la plaquette, en remplissant le trou d'un matériau conducteur et en amincissant la plaquette pour que le trou borgne débouche sur l'autre face de la plaquette.

Le document EP 1 467 315 décrit une antenne réalisée en formant une gorge dans un substrat et en remplissant la gorge d'un matériau conducteur.

Ainsi, un objectif général de la présente invention est de prévoir un procédé de fabrication d'un micromodule sans contact ne présentant pas les inconvénients des procédés connus et offrant un bon ratio qualité/coût de fabrication.

Un objectif plus particulier de la présente invention est de prévoir un procédé de fabrication qui permette de réaliser collectivement des micromodules avec un nombre minimal d'étapes d'assemblage.

Un autre objectif particulier de la présente invention est de prévoir un procédé de fabrication qui permette de réaliser des micromodules de très faible épaisseur.

Ces objectifs sont atteints par la prévision d'un procédé de fabrication d'un micromodule comprenant un circuit intégré et au moins une bobine d'antenne connectée électriquement au circuit intégré, le procédé comprenant des étapes consistant à :
- réaliser le circuit intégré et des plages de contact du circuit intégré sur une première face d'une première plaquette de matériau semi-conducteur,
- réaliser au moins un enroulement conducteur formant bobine et des plages de contact de la bobine sur une seconde plaquette de matériau semi-conducteur, et
- assembler les première et seconde plaquettes l'une contre l'autre tout en mettant les plages de contact de la bobine en contact avec des plages de contact du circuit intégré.

Selon l'invention l'enroulement conducteur est formé uniquement sur une première face de la seconde plaquette, et les plages de contact de la bobine sont formées sur une seconde face de la seconde plaquette.

Selon un mode de réalisation de l'invention, le procédé comprend des étapes consistant à :
- former des orifices traversant la seconde plaquette de part en part entre la première face sur laquelle est formé l'enroulement conducteur et la seconde face de la seconde plaquette, et
- remplir les orifices avec un matériau conducteur pour obtenir des traversées électriquement conductrices reliant l'enroulement conducteur aux plages de contact de la bobine.

Selon un mode de réalisation de l'invention, la formation des orifices comprend une étape de formation de trous borgnes sur la première face de la seconde plaquette et une étape d'amincissement de la seconde plaquette pour que les trous borgnes débouchent sur la seconde face de la seconde plaquette.

Selon un mode de réalisation de l'invention, le procédé comprend des étapes consistant à :
- former une gorge en forme d'enroulement sur la seconde plaquette, et
- remplir la gorge avec un matériau électriquement conducteur, pour obtenir l'enroulement conducteur formant bobine.

Selon un mode de réalisation de l'invention, le procédé comprend une étape de formation de bourrelets en un matériau électriquement conducteur sur les plages de contact de la bobine ou sur des plages de contact du circuit intégré, pour qu'un contact électrique entre les plages de contact de la bobine et les plages de contact du circuit intégré soit établi par les bourrelets, à la suite de l'assemblage des plaquettes.

Selon un mode de réalisation de l'invention, les bourrelets sont en un matériau appartenant à l'ensemble comprenant un métal, une composition de métaux, un alliage eutectique et un alliage dur non eutectique.

Selon un mode de réalisation de l'invention, le procédé comprend une étape d'application d'un traitement aux bourrelets, consistant en une fusion, un fluage ou un collage.

Selon un mode de réalisation de l'invention, le procédé comprend une étape de dépôt d'un matériau polymère sur la première plaquette ou sur la seconde plaquette pour assembler les deux plaquettes.

Selon un mode de réalisation de l'invention, pour la fabrication collective de micromodules, le procédé comprend des étapes consistant à :
- réaliser collectivement une pluralité de circuits intégrés et leurs plages de contact sur la première plaquette,
- réaliser collectivement une pluralité d'enroulements conducteurs formant bobine sur la seconde plaquette,
- connecter chaque enroulement conducteur à un circuit intégré au moment de l'assemblage des plaquettes, et
- découper les plaquettes après leur assemblage pour obtenir des micromodules individuels.

Selon un mode de réalisation de l'invention, pour la fabrication collective de micromodules, le procédé comprend des étapes consistant à :
- réaliser collectivement une pluralité de circuits intégrés et leurs plages de contact sur la première plaquette,
- réaliser collectivement une pluralité d'enroulements conducteurs formant bobine sur la seconde plaquette,
- découper la seconde plaquette pour obtenir une pluralité de microplaquettes chacune d'une surface correspondant sensiblement à un emplacement de circuit intégré sur la première plaquette,
- assembler des microplaquettes portant chacune une bobine avec la première plaquette de manière que chaque bobine soit connectée à un circuit intégré, et
- découper la première plaquette après son assemblage avec les microplaquettes, pour obtenir des micromodules individuels.

Selon un mode de réalisation de l'invention, pour la fabrication collective de micromodules, le procédé comprend des étapes consistant à :
- réaliser collectivement une pluralité de circuits intégrés et leurs plages de contact sur la première plaquette,
- réaliser collectivement une pluralité d'enroulements conducteurs formant bobine sur la seconde plaquette,
- découper la première plaquette pour obtenir une pluralité de microplaquettes chacune d'une surface correspondant sensiblement à un emplacement de bobine sur la seconde plaquette,
- assembler des microplaquettes portant chacune un circuit intégré avec la seconde plaquette de manière que chaque bobine soit connectée à un circuit intégré, et
- découper la seconde plaquette après son assemblage avec les microplaquettes, pour obtenir des micromodules individuels.

L'invention concerne également un micromodule comprenant un circuit intégré et au moins une bobine d'antenne comportant des plages de contact connectées électriquement à des plages de contact du circuit intégré le circuit intégré et ses plages de contact étant réalisés sur une première face d'une première microplaquette de matériau semi-conducteur, la bobine d'antenne et ses plages de contact étant réalisées sur une seconde microplaquette de matériau semi-conducteur, et les première et seconde microplaquettes étant assemblées l'une contre l'autre en mettant les plages de contact de la bobine en contact avec des plages de contact du circuit intégré qui correspondent en raison de leur emplacement aux plages de contact de la bobine.

Selon l'invention, la bobine d'antenne est agencée uniquement sur une première face de la seconde microplaquette, et les plages de contact de la bobine sont agencées sur une seconde face de la seconde microplaquette.

Selon un mode de réalisation de l'invention, la seconde microplaquette comprend des orifices remplis de matériau conducteur, traversant la microplaquette et reliant la bobine d'antenne sur la première face de la seconde microplaquette et les plages de contact de la bobine sur la seconde face de la microplaquette.

Selon un mode de réalisation de l'invention, la bobine d'antenne comprend un matériau conducteur agencé dans une gorge en forme d'enroulement présente sur la première face de la seconde microplaquette.

Selon un mode de réalisation de l'invention, le micromodule comprend des bourrelets électriquement conducteurs reliant les plages de contact de la bobine d'antenne et des plages de contact du circuit intégré qui correspondent en raison de leur emplacement aux plages de contact de la bobine d'antenne.

Selon un mode de réalisation de l'invention, le micromodule comprend un matériau polymère s'étendant entre les plages de contact de la bobine d'antenne et les plages de contact correspondantes du circuit intégré.

Ces objets, caractéristiques et avantages ainsi que d'autres de la présente invention seront exposés plus en détail dans la description suivante de l'invention faite à titre non limitatif en relation avec les figures jointes parmi lesquelles :
- la figure 1 est une vue de dessus d'une plaquette de silicium sur laquelle sont réalisés collectivement des circuits intégrés,
- la figure 2 est une vue en coupe d'une région de la plaquette de la figure 1,
- la figure 3 est une vue de dessus d'une plaquette de silicium sur laquelle sont réalisées collectivement des bobines d'antenne,
- la figure 4 est une vue en perspective d'une région de la plaquette de la figure 3,
- la figure 4A est une vue en coupe d'une partie d'une bobine d'antenne apparaissant en figure 4,
- la figure 5 est une vue de dessous de la région de plaquette représentée en figure 4,
- la figure 6 est une vue en coupe qui illustre une étape d'assemblage de la plaquette de la figure 1 et de la plaquette de la figure 3, et
- la figure 7 est une vue en coupe qui illustre une variante de l'étape d'assemblage de la figure 6.

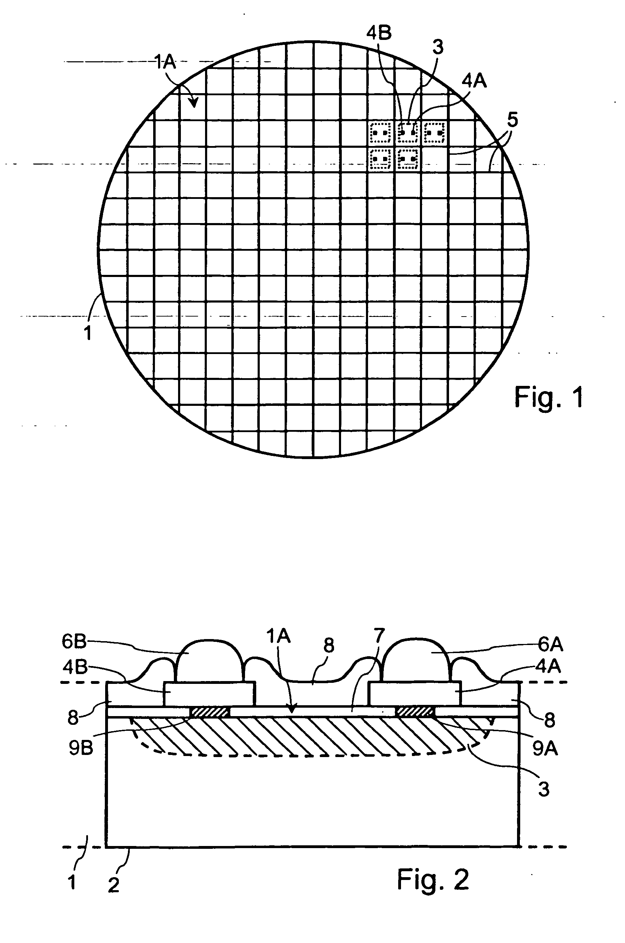

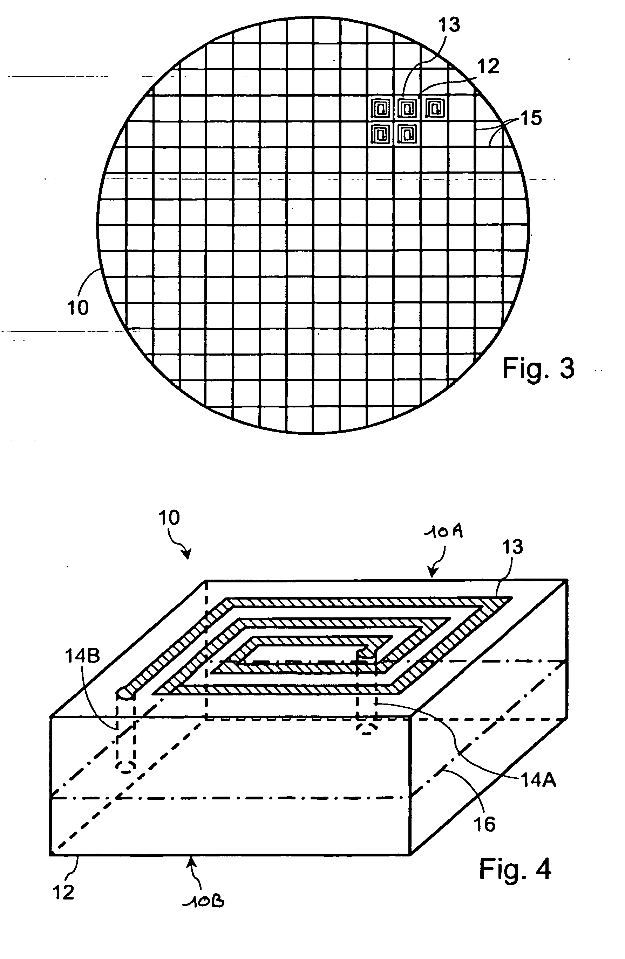

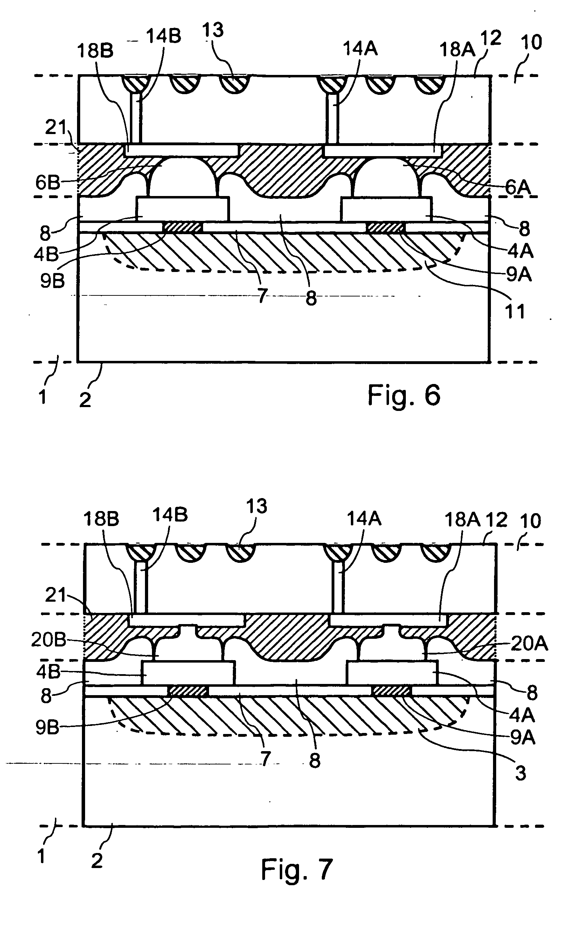

Selon un mode de réalisation préféré de l'invention, la fabrication de micromodules électroniques du type sans contact comprend les étapes suivantes :
- une étape de réalisation collective de circuits intégrés 3 sur une première plaquette de silicium 1 (premier "wafer"), illustrée sur les figures 1 et 2,
- une étape de réalisation collective de bobines d'antenne 13 sur une seconde plaquette de silicium 10 (second "wafer"), illustrée sur les figures 3, 4, 4A et 5,
- une étape d'assemblage des plaquettes 1, 10 de type "wafer contre wafer" et de connexion de chaque bobine d'antenne 13 à un circuit intégré 3, illustrée sur la figure 6, et
- une étape de découpe des plaquettes 1, 10 après assemblage (non représentée), permettant d'obtenir des micromodules individuels pré-assemblés comprenant chacun un circuit intégré 3 et une bobine d'antenne 13.

La plaquette de silicium 1 (wafer) représentée en figure 1 comprend une face active 1A sur laquelle les circuits intégrés 3 ont été implantés collectivement. Les emplacements des circuits intégrés 3 sont délimitées par des chemins de découpe 5 le long desquels la plaquette 1 sera ultérieurement découpée, formant un quadrillage sur la face active 1A.

La figure 2 est une vue en coupe d'une région 2 de la plaquette 1 correspondant à un emplacement de circuit intégré 3 délimité par des chemins de découpe (Cf. fig. 1), et représente de façon schématique la structure du circuit intégré 3 (tous les circuits intégrés de la plaquette 1 étant ici supposés identiques).

Le circuit intégré 3 comprend une région active 3-1 représentée schématiquement par une zone hachurée. Cette région active 3-1 comprend une pluralité de composants actifs et passifs obtenus par l'implantation de dopants dans la plaquette de silicium et par dépôt et/ou croissance de matériaux isolants (oxydes) et de matériaux conducteurs (métaux, polysilicium) à la surface de la plaquette de silicium. L'ensemble de ces composants actifs et passifs réalise la fonction électronique visée, ici une fonction de circuit à couplage inductif de type PICC.

Le circuit intégré 3 comprend également des plages de contact 4A, 4B pour connecter une bobine d'antenne à la région active 3-1. Les plages de contact sont reliées à la région active 3-1 par l'intermédiaire de traversées électriquement conductrices 9A, 9B qui s'étendent à travers une couche isolante 7 recouvrant toute la surface de la plaquette 1.

La face active 1A de la plaquette 1 est en outre recouverte d'une couche de protection 8 (passivation) comprenant des ouvertures aux emplacements des plages de contact 4A, 4B.

Enfin, des bourrelets (bumps) 6A, 6B d'une hauteur de l'ordre de 15 à 80 µm sont formés sur les plages de contact 4A, 4B. Les bourrelets sont en un matériau électriquement conducteur, par exemple de l'or, du cuivre, et/ou une composition de métaux telle que le nickel/or, et/ou un alliage eutectique étain-plomb ou étain-argent-cuivre ou non eutectique.

La plaquette de silicium 10 représentée en figure 3 comprend une face avant 10A sur laquelle les bobines d'antenne 13 ont été implantées collectivement. Les emplacements des bobines d'antenne 13 sont, comme les emplacements des circuits intégrés de la plaquette 1, délimités par des chemins de découpe 15 formant un quadrillage sur la face avant 10A, le long desquels la plaquette 10 sera ultérieurement découpée.

On suppose également ici que toutes les bobines d'antenne 13 sont identiques. Toutefois, si plusieurs types de circuits intégrés sont prévus sur la plaquette 1, la plaquette 10 peut comprendre des bobines de différents types, chaque type de bobine étant adapté à un type de circuit intégré.

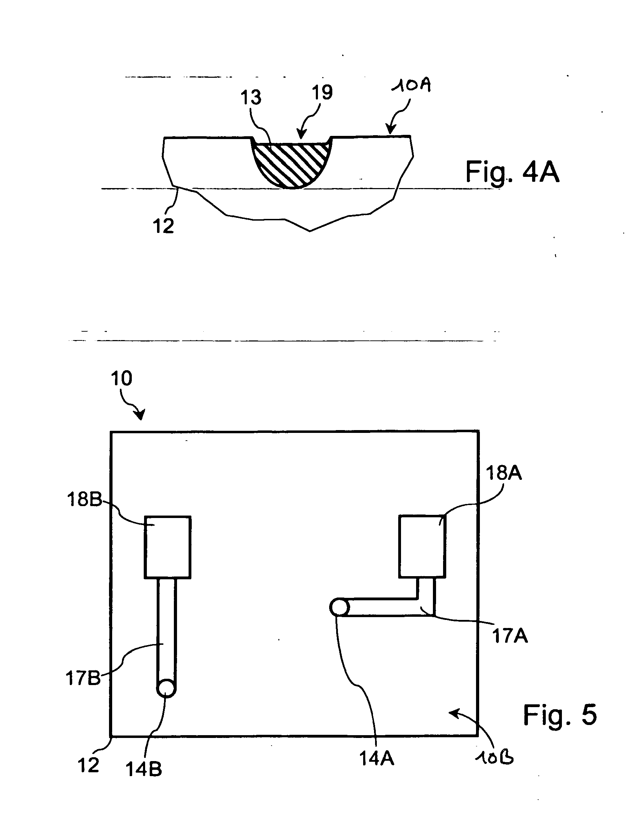

Les figures 4 et 5 représentent, respectivement par une vue de dessus et vue de dessous, une région 12 de la plaquette 10 correspondant à un emplacement de bobine d'antenne 13 délimité par des chemins de découpe (Cf. fig. 3).

Chaque bobine d'antenne 13 est réalisée en formant tout d'abord sur la face avant 10A de la plaquette 10 une gorge 19 en forme d'enroulement comportant ici une pluralité de spires coplanaires. Cette gorge, représentée en coupe sur la figure 4A, est d'une profondeur de l'ordre de 5 à 30 µm. Elle est formée par gravure sèche, gravure humique, gravure au laser ou tout autre procédé permettant de réaliser une gorge dans une plaquette de silicium.

Au cours d'une étape suivante illustrée par la figure 4, on forme dans la plaquette 10, aux extrémités de la gorge 19, des trous borgnes 14A, 14B d'une profondeur de l'ordre de 30 à 50 *µ*m et d'un diamètre d'environ 10 à 30 µm. Les trous borgnes sont par exemple réalisés en soumettant la face avant 10A de la plaquette 10 à un plasma gazeux (CF₄ ou CF₆) au travers d'un masque. Les trous borgnes peuvent également être réalisés avec un faisceau laser.

La gorge 19 ainsi que les trous borgnes 14A, 14B sont ensuite remplis avec un matériau électriquement conducteur tel que l'aluminium, le cuivre, ou l'or, ou un alliage, après dépôt d'une couche barrière (Titane, Nitrure de Titane, Tungstène,...) et, si nécessaire, d'une couche d'accrochage.

Au cours d'une étape suivante, la plaquette 10 est soumise à une étape d'amincissement (backlap) par abrasion mécanique et/ou chimique de sa face arrière 10B, jusqu'à atteindre un plan 16 tel que les trous borgnes 14A, 14B débouchent sur la face arrière 10B et forment ainsi des traversées conductrice 14A, 14B. En partant d'une épaisseur standard de la plaquette 10 de l'ordre de 700 *µ*m, l'épaisseur de la plaquette peut ainsi être ramenée à une valeur inférieure à 100 µm et avantageusement de l'ordre de 30 *µ*m, en utilisant un support permettant de manipuler la plaquette sans la briser.

Au cours d'une étape illustrée en figure 5, on forme des plages de contact 18A, 18B en face arrière 10B de la plaquette. Les plages de contact 18A, 18B sont reliées aux traversées 14A, 14B par des pistes conductrices 17A, 17B et sont positionnées de manière à être en regard des plages de contact 4A, 4B d'un circuit intégré (fig. 1 et 2) lorsque les plaquettes 1 et 10 seront assemblées. Au préalable, une couche barrière et d'accroche peut être déposée sur la face arrière 10B.

Dans une variante de réalisation, les emplacements où débouchent les traversées 14A, 14B coïncident avec les emplacements des plages de contact 4A, 4B d'un circuit intégré. Dans ce cas, les plages de contact 18A, 18B sont réalisées au-dessus des traversées 14A, 14B. Les plages de contact 18A, 18B peuvent également ne pas être prévues si les traversées 14A, 14B sont d'un diamètre suffisant pour former de bonnes plages de contact aux endroits où elles débouchent.

Les pistes conductrices 17A, 17B et, le cas échéant, les plages de contact 18A, 18B, sont réalisées par dépôt d'un conducteur au travers d'un masque de métallisation, ou de la même manière que l'enroulement formant la bobine 13, en formant des gorges dans la face arrière 10B et en remplissant les gorges avec un matériau électriquement conducteur.

La figure 6 illustre l'étape d'assemblage des plaquettes 1 et 10 (assemblage "wafer contre wafer"). Dans un souci de simplicité du dessin, seule une région 2 de la plaquette 1 du type représentée en figure 2 et une région 12 de la plaquette 10 du type représenté en figure 4 sont représentées sur la figure 6 (le schéma étant identique et répétitif pour les autres régions des plaquettes 1, 10, qui sont considérées ici comme identiques).

Au cours de cette étape d'assemblage, les plaquettes 1 et 10 sont amenées face à face de manière que les bourrelets 6A, 6B de chaque circuit intégré 3 viennent en contact avec les plages de contact 18A, 18B d'une bobine d'antenne 13 correspondante, l'alignement des plaquettes 1 et 10 étant obtenu grâce à un système de guidage équipé de caméras. De préférence, la face arrière 10B de la plaquette 10 a été préalablement recouverte d'une couche de protection 11, par exemple en polyimide, pourvue d'ouvertures aux emplacements correspondant aux plages contact 18A, 18B.

L'assemblage proprement dit des plaquettes 1 et 10 est assuré par fusion des bourrelets en présence d'une source de chaleur, par fluage des bourrelets en pressant les plaquettes l'une contre l'autre, ou par collage. A noter que dans le domaine de l'assemblage de composants par bourrelets (notamment les assemblages de type "flip chip"), les techniques les plus couramment employées à cet effet sont le fluage par compression en présence d'une source de chaleur ou le collage. Lorsque les plaquettes sont assemblées par collage, l'adhésif utilisé se présente sous forme de pâte ou de film polymère. Dans ce cas, il est nécessaire de réaliser des cheminées dans les chemins de découpe de la même façon que les via, pour permettre le dégazage des polymères de la colle durant la cuisson de cette dernière.

Comme représenté sur la figure 6, l'adhésion des deux plaquettes 1 et 10 peut être renforcée au moyen d'une pâte ou un film adhésif non conducteur 21 disposé entre les deux plaquettes avant assemblage.

En outre, la plaquette 1 peut être avantageusement amincie après son assemblage avec la plaquette 10 qui sert alors de support. L'épaisseur totale des plaquettes 1, 10 assemblées peut ainsi être réduite à environ 60*µ*m.

Les plaquettes 1, 10 assemblées sont ensuite découpées le long des chemins de découpe 5, 15, qui sont sensiblement superposées, afin d'obtenir des micromodules individuels pré-assemblés.

Il est à noter que des bourrelets peuvent également être formés sur les plages de contact 18A, 18B de la bobine.

Dans une variante illustrée par la figure 7, des bourrelets 20A, 20B présentant une partie supérieure pointue (de type "stud bump") sont disposés sur les plages de contact 4A, 4B des circuits intégrés 3. L'assemblage des plaquettes 1, 10 est effectué à l'aide d'une couche de colle ou d'un film adhésif 21 de type non conducteur ou conducteur anisotrope, qui est appliqué sur la face active 1A de la plaquette 1 et/ou la face arrière 10B de la plaquette 10. Les deux plaquettes sont ensuite pressées l'une contre l'autre de manière que la partie pointue des bourrelets 20A, 20B viennent en contact avec les plages de contact 18A, 18B. Avantageusement, la partie pointue des bourrelets s'enfonce légèrement dans les plages de contact 18A, 18B. A cet effet les plages de contact 18A, 18B sont conçues pour supporter la pénétration des bourrelets et sont réalisées dans un matériau ductile, par exemple en aluminium ou en cuivre, et les bourrelets sont réalisés en or ou en cuivre, ou encore en une composition de métaux ou en un alliage eutectique ou non eutectique. Ainsi, la connexion de la bobine au circuit intégré est effectuée ici par contact physique des bourrelets 20A, 20B et des plages de contact 18A, 18B de la bobine.

Il est à noter qu'il est également nécessaire de réaliser des cheminées dans les chemins de découpe de la même façon que les via, pour permettre le dégazage des polymères de la colle durant la cuisson de cette dernière.

Comme précédemment, les plaquettes 1 et 10, une fois assemblées, sont découpées simultanément le long des chemins de découpe 5, 15 pour obtenir des micromodules pré-assemblés. Avant cette étape de découpe, la plaquette 1 peut également être amincie, de manière à atteindre une épaisseur totale des plaquettes 1, 10 assemblées d'environ 60µm.

L'usage de bourrelets 20A, 20B pointus permet de réduire l'épaisseur du micromodule de plusieurs dizaines de micromètres (idéalement environ 60 *µ*m) par rapport au micromodule illustré sur la figure 6, dans lequel des bourrelets arrondis ont été utilisés. Par contre, il est préférable de ne pas former des bourrelets de ce type sur les plages de contact 18A, 18B de la bobine, car ils risqueraient d'enfoncer les plages de contact du circuit intégré et d'endommager le circuit intégré lui-même lors de l'assemblage des plaquettes.

Ainsi, le micromodule selon l'invention est obtenu à partir d'une plaquette de silicium dédiée à la région active 3-1 du circuit intégré 3, et d'une autre plaquette de silicium dédiée à l'antenne 13 du micromodule. Le fait que l'antenne soit réalisée dans une plaquette de silicium dédiée, tout comme le circuit intégré, permet de s'affranchir des contraintes mécaniques qui apparaissent lorsque la plaquette n'a pas les mêmes propriétés de dilatation thermique que le circuit intégré. Le procédé selon l'invention offre en outre un rendement de fabrication bien plus élevé que les procédés "coil on chip". Il permet également de bénéficier des techniques d'amincissement des plaquettes de silicium, et de réaliser un micromodule de très faible épaisseur.

Dans le micromodule ainsi obtenu, la face active est couverte par la plaquette dédiée à l'antenne, qui protège ainsi la face active contre des attaques visant à analyser le fonctionnement du circuit intégré.

La plaquette 10 dédiée à l'antenne peut être une plaquette recyclée. En effet, la face arrière de la plaquette peut être utilisée à la formation de l'antenne, tandis que la face active de la plaquette est supprimée lors de l'étape d'amincissement.

L'étape d'amincissement de la plaquette 10 permet en outre de faire apparaître une surface de contact suffisante à une bonne connexion.

Il est à noter que, comme la plaquette 10 recouvre la face active de la plaquette 1, des plages de contact du circuit intégré peuvent être masquées par la plaquette 10. Pour rendre accessibles ces plages de contact, des trous sont réalisés dans la plaquette 10 en regard des plages de contacts à rendre accessibles, et sont métallisés de la même façon que les trous borgnes 14A, 14B.

En sus des variantes technologiques qui viennent d'être décrites, le procédé de fabrication selon l'invention est susceptible d'autres modes de réalisation, notamment en ce qui concerne l'ordre de mise en oeuvre des étapes de découpe et d'assemblage des plaquettes 1, 10.

Ainsi, dans un second mode de réalisation, la plaquette 1 est préalablement découpée suivant ses chemins de découpe pour obtenir une pluralité de microplaquettes 2 comportant chacune un circuit intégré 3 et correspondant chacune à une région 2 du type décrit plus haut (fig. 1 et 2). Chaque microplaquette 2 est ensuite assemblée sur la plaquette 10 et est connectée à une bobine 13 avant découpe de la plaquette 10.

Dans un troisième mode de réalisation, c'est la plaquette 10 qui est préalablement découpée suivant ses chemins de découpe pour obtenir une pluralité de microplaquettes 12 comportant chacune une bobine d'antenne 13 et correspondant chacune à une région 12 du type décrit plus haut (fig. 3, 4 et 5). Chaque microplaquette 12 est ensuite assemblée sur la plaquette 1 et est connectée à un circuit intégré 3 avant découpe de la plaquette 1.

Ces modes de réalisation autorisent notamment une différence de dimensions entre la région 12 recevant la bobine 13 et la région 2 recevant le circuit intégré 3. Si la région la plus petite est découpée avant l'étape d'assemblage, elle peut être réalisée en plus grand nombre sur une même plaquette de silicium que l'autre région. La surface des deux plaquettes peut ainsi être utilisée au maximum.

Il apparaîtra clairement à l'homme de l'art que les diverses étapes de fabrication décrites dans ce qui précède, notamment de montage, d'assemblage, de connexion et de réalisation de plages de contact et de liaisons électriques, ne nécessitent que la mise en oeuvre de techniques couramment employées dans l'industrie de la microélectronique.

Il apparaîtra également à l'homme de l'art que le procédé selon l'invention est susceptible de divers autres modes de réalisation.

Ainsi, les plages de contact 18A, 18B des bobines 13 peuvent être réalisées sur la même face que les bobines 13. Dans ce cas, la face avant 10A (fig. 3) de la plaquette 10 est orientée vers la face active 1A (fig. 1) de la plaquette 2 au moment de l'assemblage. Les pistes conductrices 17A, 17B permettant de faire coïncider les plages de contact des circuits intégrés et les plages de contact des bobines sont alors de préférence réalisées sur la plaquette 10 plutôt que sur la plaquette 2.

Par ailleurs, dans le cas d'une découpe de la plaquette 10 avant assemblage, les traversées 14A, 14B peuvent être remplacées par des pistes conductrices passant sur une tranche préalablement biseautée des microplaquettes 12.

D'autre part, il peut ne pas être nécessaire de réaliser les bobines d'antenne dans des gorges creusées dans la plaquette 10, bien que cela offre l'avantage de diminuer le nombre d'étapes de traitement. Ainsi, les enroulements peuvent également être réalisés directement par dépôt de métal à la surface de la plaquette 10, après dépôt d'une couche barrière et éventuellement d'une couche d'accrochage.

Chaque circuit intégré 3 peut par ailleurs comporter d'autres plages de contact, notamment des plages de test ou des plages permettant de le connecter, en sus de sa connexion avec la bobine d'antenne, à des contacts de carte à puce de type ISO/IEC 7816. Dans ce cas, l'invention permet de réaliser des micromodules à deux modes de fonctionnement, avec et sans contact.

Egalement, un micromodule selon l'invention peut comprendre plusieurs bobines d'antenne, certains micromodules sans contact utilisant par exemple une première bobine d'antenne pour l'émission et la réception de données et une seconde bobine d'antenne pour recevoir de l'énergie électrique. Ainsi, dans chaque région 12 de la plaquette 10, une bobine d'antenne peut être prévue sur chaque face de la plaquette 10. Dans chaque région 12 de la plaquette 10, deux bobines peuvent également être agencées sur la même face de la plaquette 10, soit côte à côte soit superposées et séparées par une couche isolante.

Bien que l'on ait décrit dans ce qui précède une application de l'invention aux circuits intégrés de type PICC, une antenne de type UHF (par exemple une antenne en Y) peut également être prévue à la place de la bobine d'antenne décrite plus haut

Enfin, le procédé de fabrication selon l'invention peut être mis en oeuvre avec tous types de plaquettes pouvant recevoir des bobines d'antenne et des circuits intégrés, par exemple des plaquettes en arséniure de gallium AsGa.

## Revendications

1. Procédé de fabrication d'un micromodule comprenant un circuit intégré (3) et au moins une bobine d'antenne connectée électriquement au circuit intégré,comprenant des étapes consistant à :
- réaliser le circuit intégré (3) et des plages de contact (4A, 4B) du circuit intégré sur une première face d'une première plaquette (1, 2) de matériau semi-conducteur,
- réaliser au moins un enroulement conducteur (13) formant bobine et des plages de contact (18A, 18B) de la bobine sur une seconde plaquette (10, 12) de matériau semi-conducteur, et
- assembler les première et seconde plaquettes l'une contre l'autre tout en mettant les plages de contact de la bobine en contact avec des plages de contact du circuit intégré,
**caractérisé en que** :
- l'enroulement conducteur (13) est formé uniquement sur une première face (10A) de la seconde plaquette (10), et
- les plages de contact (18A, 18B) de la bobine sont formées sur une seconde face (10B) de la seconde plaquette (10).

2. Procédé selon la revendication 1, comprenant des étapes consistant à :
- former des orifices (14A, 14B) traversant la seconde plaquette (10, 12) de part en part entre la première face (10A) sur laquelle est formé l'enroulement conducteur (13) et la seconde face (10B) de la seconde plaquette, et
- remplir les orifices avec un matériau conducteur pour obtenir des traversées électriquement conductrices reliant l'enroulement conducteur (13) aux plages de contact (18A, 18B) de la bobine.

3. Procédé selon la revendication 2, dans lequel la formation des orifices (14A, 14B) comprend une étape de formation de trous borgnes sur la première face (10A) de la seconde plaquette (10, 12) et une étape d'amincissement de la seconde plaquette pour que les trous borgnes débouchent sur la seconde face (10B) de la seconde plaquette.

4. Procédé selon l'une des revendications 1 à 3, comprenant des étapes consistant à :
- former une gorge (19) en forme d'enroulement sur la seconde plaquette (10, 12), et
- remplir la gorge avec un matériau électriquement conducteur, pour obtenir l'enroulement conducteur (13) formant bobine.

5. Procédé selon l'une des revendications 1 à 4, comprenant une étape de formation de bourrelets (6A, 6B ; 20A, 20B) en un matériau électriquement conducteur sur les plages de contact (18A, 18B) de la bobine ou sur des plages de contact (4A, 4B) du circuit intégré (3), pour qu'un contact électrique entre les plages de contact de la bobine et les plages de contact du circuit intégré soit établi par les bourrelets, à la suite de l'assemblage des plaquettes (1, 2, 10, 12).

6. Procédé selon la revendication 5, dans lequel les bourrelets (6A, 6B ; 20A, 20B) sont en un matériau appartenant à l'ensemble comprenant un métal, une composition de métaux, un alliage eutectique et un alliage dur non eutectique.

7. Procédé selon la revendication 5 ou 6, comprenant une étape d'application d'un traitement aux bourrelets (6A, 6B), consistant en une fusion, un fluage ou un collage.

8. Procédé selon l'une des revendications 1 à 7, comprenant une étape de dépôt d'un matériau polymère sur la première plaquette (1, 2) ou sur la seconde plaquette (10, 12) pour assembler les deux plaquettes.

9. Procédé selon l'une des revendications 1 à 8, pour la fabrication collective de micromodules, comprenant des étapes consistant à :
- réaliser collectivement une pluralité de circuits intégrés (3) et leurs plages de contact (4A, 4B) sur la première plaquette (1),
- réaliser collectivement une pluralité d'enroulements conducteurs (13) formant bobine sur la seconde plaquette (10),
- connecter chaque enroulement conducteur (13) à un circuit intégré (3) au moment de l'assemblage des plaquettes, et
- découper les plaquettes (1, 10) après leur assemblage pour obtenir des micromodules individuels.

10. Procédé selon l'une des revendications 1 à 8, pour la fabrication collective de micromodules, comprenant des étapes consistant à :
- réaliser collectivement une pluralité de circuits intégrés (3) et leurs plages de contact (4A, 4B) sur la première plaquette (1),
- réaliser collectivement une pluralité d'enroulements conducteurs (13) formant bobine sur la seconde plaquette (10),
- découper la seconde plaquette pour obtenir une pluralité de microplaquettes (12) chacune d'une surface correspondant sensiblement à un emplacement (2) de circuit intégré (3) sur la première plaquette (1),
- assembler des microplaquettes (12) portant chacune une bobine avec la première plaquette (1) de manière que chaque bobine soit connectée à un circuit intégré, et
- découper la première plaquette après son assemblage avec les microplaquettes, pour obtenir des micromodules individuels.

11. Procédé selon l'une des revendications 1 à 8, pour la fabrication collective de micromodules, comprenant des étapes consistant à :
- réaliser collectivement une pluralité de circuits intégrés et leurs plages de contact (4A, 4B) sur la première plaquette (1),
- réaliser collectivement une pluralité d'enroulements conducteurs (13) formant bobine sur la seconde plaquette (10),
- découper la première plaquette pour obtenir une pluralité de microplaquettes (2) chacune d'une surface correspondant sensiblement à un emplacement de bobine sur la seconde plaquette,
- assembler des microplaquettes (2) portant chacune un circuit intégré avec la seconde plaquette (10) de manière que chaque bobine soit connectée à un circuit intégré, et
- découper la seconde plaquette après son assemblage avec les microplaquettes, pour obtenir des micromodules individuels.

12. Micromodule comprenant un circuit intégré (3) et au moins une bobine d'antenne (13) comportant des plages de contact (18A, 18B) connectées électriquement à des plages de contact (4A, 4B) du circuit intégré, le circuit intégré (3) et ses plages de contact (4A, 4B) étant réalisés sur une première face d'une première microplaquette (2) de matériau semi-conducteur, la bobine d'antenne (13) et ses plages de contact (18A, 18B) étant réalisées sur une seconde microplaquette (12) de matériau semi-conducteur, et les première et seconde microplaquettes étant assemblées l'une contre l'autre en mettant les plages de contact de la bobine en contact avec des plages de contact du circuit intégré qui correspondent en raison de leur emplacement aux plages de contact de la bobine,
**caractérisé en que** la bobine d'antenne (13) est agencée uniquement sur une première face (10A) de la seconde microplaquette (12), et les plages de contact (18A, 18B) de la bobine sont agencées sur une seconde face (10B) de la seconde microplaquette.

13. Micromodule selon la revendication 12, dans lequel la seconde microplaquette (12) comprend des orifices (14A, 14B) remplis de matériau conducteur, traversant la microplaquette et reliant la bobine d'antenne (13) sur la première face (10A) de la seconde microplaquette (12) et les plages de contact (18A, 18B) de la bobine sur la seconde face de la microplaquette.

14. Micromodule selon l'une des revendications 12 à 13, dans lequel la bobine d'antenne comprend un matériau conducteur agencé dans une gorge (19) en forme d'enroulement présente sur la première face (10A) de la seconde microplaquette (12).

15. Micromodule selon l'une des revendications 12 à 14, comprenant des bourrelets (6A, 6B ; 20A, 20B) électriquement conducteurs reliant les plages de contact (18A, 18B) de la bobine d'antenne et des plages de contact (4A, 4B) du circuit intégré (3) qui correspondent en raison de leur emplacement aux plages de contact de la bobine d'antenne.

16. Micromodule selon l'une des revendications 12 à 15, comprenant un matériau polymère s'étendant entre les plages de contact (18A, 18B) de la bobine d'antenne et les plages de contact (4A, 4B) correspondantes du circuit intégré (3).

## Claims

1. Method for manufacturing a micromodule comprising an integrated circuit (3) and at least one antenna coil electrically connected to the integrated circuit, comprising:
- manufacturing the integrated circuit (3) and contact pads (4A, 4B) of the integrated circuit on a first face of a first wafer (1, 2) of semiconductor material,
- manufacturing at least one conductive winding (13) forming a coil and contact pads (18A, 18B) of the coil on a second wafer (10, 12) of semiconductor material, and
- assembling the first and second wafers one against the other while contacting the contact pads of the coil with the contact pads of the integrated circuit,
**characterised in that:**
- the conductive winding (13) is only formed on a first face (10A) of the second wafer (10), and
- the contact pads (18A, 18B) of the coil are formed on a second face (10B) of the second wafer (10).

2. Method according to claim 1, comprising:
- forming orifices (14A, 14B) going through the second wafer (10, 12) between the first face (10A) on which the conductive winding (13) is formed and the second face (10B) of the second wafer, and
- filling in the orifices with a conductive material to obtain electrically conductive vias linking the conductive winding (13) to the contact pads (18A, 18B) of the coil.

3. Method according to claim 2, wherein forming the orifices (14A, 14B) comprises forming blind holes on the first face (10A) of the second wafer (10, 12) and thinning the second wafer so that the blind holes open onto the second face (10B) of the second wafer.

4. Method according to one of claims 1 to 3, comprising:
- forming a winding-shaped groove (19) on the second wafer (10, 12), and
- filling in the groove with an electrically conductive material, to obtain the conductive winding (13) forming a coil.

5. Method according to one of claims 1 to 4, comprising forming bumps (6A, 6B ; 20A, 20B) in an electrically conductive material on the contact pads (18A, 18B) of the coil or on contact pads (4A, 4B) of the integrated circuit (3), so that an electrical contact between the contact pads of the coil and the contact pads of the integrated circuit is made by the bumps, after assembling the wafers (1, 2, 10, 12).

6. Method according to claim 5, wherein the bumps (6A, 6B ; 20A, 20B) are in a material belonging to the group comprising a metal, a composition of metals, an eutectic alloy and a not eutectic hard alloy.

7. Method according to claim 5 or 6, comprising applying a treatment to the bumps (6A, 6B), consisting in fusing, creeping or gluing.

8. Method according to one of claims 1 to 7, comprising depositing a polymer material onto the first wafer (1, 2) or the second wafer (10, 12) to assemble both wafers.

9. Method according to one of claims 1 to 8, for the collective manufacture of micromodules, comprising:
- collectively manufacturing a plurality of integrated circuits (3) and the contact pads thereof (4A, 4B) on the first wafer (1),
- collectively manufacturing a plurality of conductive windings (13) forming a coil on the second wafer (10),
- connecting each conductive winding (13) to an integrated circuit (3) at the time of assembling the wafers, and
- cutting the wafers (1, 10) after assembling them to obtain individual micromodules.

10. Method according to one of claims 1 to 8, for the collective manufacture of micromodules, comprising:
- collectively manufacturing a plurality of integrated circuits (3) and the contact pads thereof (4A, 4B) on the first wafer (1),
- collectively manufacturing a plurality of conductive windings (13) forming a coil on the second wafer (10),
- cutting the second wafer to obtain a plurality of chips (12), each chip having a surface substantially corresponding to a location (2) of integrated circuit (3) on the first wafer (1),
- assembling chips (12), each chip being fitted with a coil, with the first wafer (1) so that each coil is connected to an integrated circuit, and
- cutting the first wafer after assembling it with the chips, to obtain individual micromodules.

11. Method according to one of claims 1 to 8, for the collective manufacture of micromodules, comprising:
- collectively manufacturing a plurality of integrated circuits and the contact pads thereof (4A, 4B) on the first wafer (1),
- collectively manufacturing a plurality of conductive windings (13) forming a coil on the second wafer (10),
- cutting the first wafer to obtain a plurality of chips (2), each chip having a surface substantially corresponding to a coil location on the second wafer,
- assembling the chips (2), each chip being fitted with an integrated circuit, with the second wafer (10) so that each coil is connected to an integrated circuit, and
- cutting the second wafer after assembling it with the chips, to obtain individual micromodules.

12. Micromodule comprising an integrated circuit (3) and at least one antenna coil (13) comprising contact pads (18A, 18B) electrically connected to contact pads (4A, 4B) of the integrated circuit, the integrated circuit (3) and the contact pads thereof (4A, 4B) being made on a first face of a first chip (2) of semiconductor material, the antenna coil (13) and the contact pads thereof (18A,18B) being made on a second chip (12) of semiconductor material, and the first and second chips being assembled one against the other by contacting the contact pads of the coil with the contact pads of the integrated circuit which correspond to the contact pads of the coil due to their locations,
**characterised in that** the antenna coil (13) is only arranged on a first face (10A) of the second chip (12), and the contact pads (18A, 18B) of the coil are arranged on a second face (10B) of the second chip.

13. Micromodule according to claim 12, wherein the second chip (12) comprises orifices (14A, 14B) filled in with conductive material, going through the chip and linking the antenna coil (13) on the first face (10A) of the second chip (12) with the contact pads (18A, 18B) of the coil on the second face of the chip.

14. Micromodule according to one of claims 12 to 13, wherein the antenna coil comprises a conductive material arranged in a winding-shaped groove (19) present on the first face (10A) of the second chip (12).

15. Micromodule according to one of claims 12 to 14, comprising electrically conductive bumps (6A, 6B ; 20A, 20B) linking the contact pads (18A, 18B) of the antenna coil with the contact pads (4A, 4B) of the integrated circuit (3) which correspond to the contact pads of the antenna coil due to their locations.

16. Micromodule according to one of claims 12 to 15, comprising a polymer material spreading out between the contact pads (18A, 18B) of the antenna coil and the corresponding contact pads (4A, 4B) of the integrated circuit (3).

## Patentansprüche

1. Verfahren zum Herstellen eines Mikromoduls, das einen integrierten Schaltkreis (3) und mindestens eine Antennenspule, die elektrisch an den integrierten Schaltkreis angeschlossen ist, aufweist, das die folgenden Schritte aufweist:
- Herstellen des integrierten Schaltkreises (3) und der Kontaktbereiche (4A, 4B) des integrierten Schaltkreises auf einer ersten Seite einer ersten Platte (1, 2) aus Halbleiterwerkstoff,
- Herstellen mindestens einer leitenden Wicklung (13), die eine Spule bildet, und der Kontaktbereiche (18A, 18B) der Spule auf einer zweiten Platte (10, 12) aus Halbleiterwerkstoff, und
- Zusammenfügen der ersten und der zweiten Platte eine gegen die andere, wobei gleichzeitig die Kontaktbereiche der Spule mit den Kontaktbereichen des integrierten Schaltkreises in Berührung gebracht werden,
**dadurch gekennzeichnet,**
- **dass** die leitende Wicklung (13) nur auf einer ersten Seite (10A) der zweiten Platte (10) ausgebildet ist, und
- **dass** die Kontaktbereiche (18A, 18B) der Spule auf einer zweiten Seite (10B) der zweiten Platte (10) ausgebildet sind.

2. Verfahren nach Anspruch 1, das folgende Schritte aufweist:
- Bilden von Öffnungen (14A, 14B), die die zweite Platte (10, 12) zwischen der ersten Seite (10A), auf der die leitende Wicklung (13) ausgebildet ist, und der zweiten Seite (10B) der zweiten Platte ganz durchqueren, und
- Füllen der Öffnungen mit einem leitenden Werkstoff, um elektrisch leitende Durchgänge, die die leitende Wicklung (13) mit den Kontaktbereichen (18A, 18B) der Spule verbinden, zu erzielen.

3. Verfahren nach Anspruch 2, bei dem das Ausbilden der Öffnungen (14A, 14B) einen Schritt des Ausbildens von Sacklöchern auf der ersten Seite (10A) der zweiten Platte (10, 12) und einen Schritt des Verdünnens der zweiten Platte, damit die Sacklöcher auf der zweiten Seite (10B) der zweiten Platte münden, aufweist.

4. Verfahren nach einem der Ansprüche 1 bis 3, das die folgenden Schritte aufweist:
- Bilden einer Hohlkehle (19) in Wicklungsform auf der zweiten Platte (10, 12) und
- Füllen der Hohlkehle mit einem elektrisch leitenden Werkstoff, um die leitende Wicklung (13), die eine Spule bildet, zu erzielen.

5. Verfahren nach einem der Ansprüche 1 bis 4, das einen Schritt des Herstellens von Wülsten (6A, 6B; 20A, 20B) aus einem elektrisch leitenden Werkstoff auf den Kontaktbereichen (18A, 18B) der Spule oder auf den Kontaktbereichen (4A, 4B) des integrierten Schaltkreises (3) aufweist, damit ein elektrischer Kontakt zwischen den Kontaktbereichen der Spule und den Kontaktbereichen des integrierten Schaltkreises durch die Wülste in Folge des Zusammenfügens der Platten (1, 2, 10, 12) erstellt wird.

6. Verfahren nach Anspruch 5, bei dem die Wülste (6A, 6B; 20A, 20B) aus einem Werkstoff bestehen, der zu einer Einheit gehört, die ein Metall, eine Verbindung von Metallen, eine eutektische Legierung und eine harte, nicht eutektische Legierung aufweist.

7. Verfahren nach Anspruch 5 oder 6, das einen Schritt des Anwendens einer Behandlung an die Wülste (6A, 6B) aufweist, der aus einem Schmelzen, einem Fließen oder einem Kleben besteht.

8. Verfahren nach einem der Ansprüche 1 bis 7, das einen Schritt des Ablagerns eines Polymerwerkstoffs auf der ersten Platte (1, 2) oder auf der zweiten Platte (10, 12) zum Zusammenfügen der zwei Platten aufweist.

9. Verfahren nach einem der Ansprüche 1 bis 8 zum gemeinsamen Herstellen von Mikromodulen, das die folgenden Schritte aufweist:
- gemeinsames Herstellen mehrerer integrierter Schaltkreise (3) und ihrer Kontaktbereiche (4A, 4B) auf der ersten Platte (1),
- gemeinsames Herstellen mehrerer leitender Wicklungen (13), die auf der zweiten Platte (10) eine Spule bilden,
- Verbinden jeder leitenden Wicklung (13) mit einem integrierten Schaltkreis (3) im Augenblick des Zusammenfügens der Platten, und
- Ausschneiden der Platten (1, 10) nach ihrem Zusammenfügen, um einzelne Mikromodule zu erzielen.

10. Verfahren nach einem der Ansprüche 1 bis 8 zum gemeinsamen Herstellen von Mikromodulen, das die folgenden Schritte aufweist:
- gemeinsames Herstellen mehrerer integrierter Schaltkreise (3) und ihrer Kontaktbereiche (4A, 4B) auf der ersten Platte (1),
- gemeinsames Herstellen mehrerer leitender Wicklungen (13), die auf der zweiten Platte (10) eine Spule bilden,
- Ausschneiden der zweiten Platte, um mehrere Mikroplatten (12) zu erzielen, jede mit einer Fläche, die im Wesentlichen einer Lage (2) eines integrierten Schaltkreises (3) auf der ersten Platte (1) entspricht,
- Zusammenfügen der Mikroplatten (12), die jeweils eine Spule tragen, mit der ersten Platte (1) derart, dass jede Spule an einen integrierten Schaltkreis angeschlossen ist, und
- Ausschneiden der ersten Platte nach ihrem Zusammenfügen mit den Mikroplatten, um einzelne Mikromodule zu erzielen.

11. Verfahren nach einem der Ansprüche 1 bis 8 zum gemeinsamen Herstellen von Mikromodulen, das die folgenden Schritte aufweist:
- gemeinsames Herstellen mehrerer integrierter Schaltkreise und ihrer Kontaktbereiche (4A, 4B) auf der ersten Platte (1),
- gemeinsames Herstellen mehrerer leitender Wicklungen (13), die auf der zweiten Platte (10) eine Spule bilden,
- Ausschneiden der ersten Platte, um mehrere Mikroplatten (2) zu erzielen, jeweils mit einer Fläche, die im Wesentlichen einer Lage einer Spule auf der zweiten Platte entspricht,
- Zusammenfügen der Mikroplatten (2), die jeweils einen integrierten Schaltkreis tragen, mit der zweiten Platte (10) derart, dass jede Spule an einen integrierten Schaltkreis angeschlossen ist, und
- Ausschneiden der zweiten Platte nach ihrem Zusammenfügen mit den Mikroplatten, um einzelne Mikromodule zu erzielen.

12. Mikromodul, das einen integrierten Schaltkreis (3) und mindestens eine Antennenspule (13) aufweist, das Kontaktbereiche (18A, 18B) aufweist, die elektrisch an Kontaktbereiche (4A, 4B) des integrierten Schaltkreises angeschlossen sind, wobei der integrierte Schaltkreis (3) und seine Kontaktbereiche (4A, 4B) auf einer ersten Seite einer ersten Mikroplatte (2) aus Halbleiterwerkstoff hergestellt sind, wobei die Antennenspule (13) und ihre Kontaktbereiche (18A, 18B) auf einer zweiten Mikroplatte (12) aus Halbleiterwerkstoff hergestellt sind, und wobei die erste und die zweite Mikroplatte gegeneinander zusammengefügt werden, indem die Kontaktbereiche der Spule mit den Kontaktbereichen des integrierten Schaltkreises, die aufgrund ihrer Lage den Kontaktbereichen der Spule entsprechen, in Berührung gebracht werden,
**dadurch gekennzeichnet, dass** die Antennenspule (13) nur auf einer ersten Seite (10A) der zweiten Mikroplatte (12) angeordnet ist, und dass die Kontaktbereiche (18A, 18B) der Spule auf einer zweiten Seite (10B) der zweiten Mikroplatte angeordnet sind.

13. Mikromodul nach Anspruch 12, bei dem die zweite Mikroplatte (12) Öffnungen (14A, 14B) aufweist, die mit leitendem Werkstoff gefüllt sind, die die Mikroplatte durchqueren und die Antennenspule (13) auf der ersten Seite (10A) der zweiten Mikroplatte (12) und die Kontaktbereiche (18A, 18B) der Spule auf der zweiten Seite der Mikroplatte verbinden.

14. Mikromodul nach einem der Ansprüche 12 bis 13, bei dem die Antennenspule einen leitenden Werkstoff aufweist, der in einer Hohlkehle (19) in Wicklungsform, die auf der ersten Seite (10A) der zweiten Mikroplatte (12) vorhanden ist, eingerichtet ist.

15. Mikromodul nach einem der Ansprüche 12 bis 14, das Wülste (6A, 6B; 20A, 20B) aufweist, die elektrisch leitend sind, die die Kontaktbereiche (18A, 18B) der Antennenspule und Kontaktbereiche (4A, 4B) des integrierten Schaltkreises (3), die aufgrund ihrer Lage den Kontaktbereichen der Antennenspule entsprechen, verbinden.

16. Mikromodul nach einem der Ansprüche 12 bis 15, das einen Polymerwerkstoff aufweist, der sich zwischen den Kontaktbereichen (18A, 18B) der Antennen und den entsprechenden Kontaktbereichen (4A, 4B) des integrierten Schaltkreises (3) erstrecken.
